# EUROPEAN PATENT APPLICATION

(11) **EP 3 879 567 A1**
(43) Date of publication of application: **15.09.2021**
(21) Application number: 19881136.6
(22) Date of filing: 18.10.2019
(51) Int. Cl.: H01L 23/32, H01B 13/00, H01R 11/01, H01R 43/00, H05K 1/11, H05K 3/40

(54) **METHOD FOR MANUFACTURING CONDUCTIVE MEMBER**

(30) Priority: 05.11.2018 JP 2018208166
(71) Applicant: NOK Corporation, Minato-ku Tokyo 105-8585 (JP)
(72) Inventor: SUGIYAMA, Yasushi, Tsujido-shinmachi, Fujisawa-shi, Kanagawa 251-0042 (JP)
(74) Representative: TBK
(86) International application number: PCT/JP2019/041140
(87) International publication number: WO 2020/095656

(57) **Abstract**

Provided is a manufacturing method of a conductive member for electrical test that can accommodate downsizing of an electronic component.

On a glass substrate (1) formed with a plurality of through holes (2), an electrode-portion forming step of forming an electrode portion (3) in each of the through holes (2), a resin-material layer forming step of forming a resin-material layer on a topside (11) of the glass substrate (1), a via-hole forming step of forming a via hole in a resin-material layer formed on the glass substrate (1) at a location atop the electrode portion (3), a filling step of filling the via hole with a conductive elastic material, a semi-hardening step of semi-hardening the conductive elastic material, a separation step of separating the resin-material layer (6), an insulation-portion forming step of forming an insulation portion (5) on the topside (11) of the glass substrate (1) by using an insulating elastic material, and a hardening step of hardening the insulation portion (5) along with the conductive elastic material are performed.

## Description

### Technical Field

The present invention relates to a manufacturing method of a conductive member.

### Background Art

An electrical test to check for a conducting state of an electrode of an electronic component such as a semiconductor integrated circuit is commonly known as bringing the above electrode into contact with a conducting portion of a testing device. A conductive member is commonly known as being interposed between the above electrode to be tested and the above conducting portion when an electrical test is carried out, in consideration of protecting the above electrode, and bringing this electrode into proper contact with the above conducting portion (For example, see Patent Literatures 1 and 2).

Patent Literature 1 discloses a technique of an anisotropic conducting rubber sheet including a conducting portion within an electrically-insulating material, in which the conducting portion is electrically connectable to a terminal electrode of a tested object, and includes a connection portion provided with an engaged portion with which the terminal electrode of the tested object is engaged.

Patent Literature 2 discloses a technique configured to include an elastic conducting sheet including a first conducting portion and an insulating support portion that supports the first conducting portion while insulating the first conducting portion from the adjacent first conducting portion, a support sheet affixed to the elastic conducting sheet and formed with a through hole at a position corresponding to a terminal of a tested device, and a second conducting portion located within the through hole on the support sheet with a large number of second conductive particles located in a thickness direction within an elastic material of the second conducting portion.

### Document List

### Patent Literature

Patent Literature 1: Japanese Patent Application Publication No. H11-214594
Patent Literature 2: National Publication of International Patent Application No. 2015-501427

### Summary of Invention

### Technical Problem

Electronic components that are the object to be electrically tested have been increasingly downsized. As a technique to downsize the electronic components, a BGA (Ball grid array) package is commonly known, for example. In the BGA package, a semiconductor chip is mounted on a package substrate, and hemispherical solders (solder balls) are provided to serve as electrodes at the bottom portion of the package substrate. In an electronic component including the BGA package, a solder-ball pitch, that is, an electrode pitch can be set to, for example, approximately 500 µm, so that the connection area of the electrodes with an electronic circuit substrate can be relatively small.

It is conceivable that as performance of the recent electronic components becomes more advanced, packages are further downsized with more highly-dense integration in the package, and accordingly the electrode pitch is further reduced to, for example, 55 µm.

However, in a case where an electrical test is carried out on an electronic component with such a reduced electrode pitch as described above, it is difficult for the conventional techniques including those disclosed in Patent Literatures 1 and 2 to manufacture a conductive member provided with a conducting portion and an insulation portion corresponding to the reduced electrode pitch. Specifically, it is difficult for the conventional techniques to manufacture a conductive member with a mechanical strength sufficient for a pressing force applied by a testing device during an electrical test. In addition, it is difficult for the conventional techniques to provide a conducting portion corresponding to a reduced electrode pitch with high accuracy.

The present invention has been made in view of the above problems, and it is an object of the present invention to provide a manufacturing method of a conductive member for electrical test that can accommodate downsizing of an electronic component.

### Solution to Problem

To achieve the above object, a manufacturing method of a conductive member according to the present invention includes: an electrode-portion forming step of, on a glass substrate formed with a plurality of through holes at a predetermined pitch, forming an electrode portion in each of the through holes; a resin-material layer forming step of forming a resin-material layer on a topside of the glass substrate; a via-hole forming step of forming a via hole in a resin-material layer formed on the glass substrate at a position atop the electrode portion; a filling step of filling the via hole with a conductive elastic material; a semi-hardening step of semi-hardening the conductive elastic material; a separation step of separating the resin-material layer; an insulation-portion forming step of forming an insulation portion on a topside of the glass substrate by using an insulating elastic material; and a hardening step of hardening the insulation portion along with the conductive elastic material.

In the manufacturing method of a conductive member according to one aspect of the present invention, the resin-material layer is formed of a resin material with photosensitivity, and in the via-hole forming step, the via hole is formed by performing a photolithography process on the resin-material layer at a position atop the electrode portion.

In the manufacturing method of a conductive member according to one aspect of the present invention, the resin-material layer is separated from a topside of the glass substrate by an etching process.

In the manufacturing method of a conductive member according to one aspect of the present invention, the insulating elastic material is a silicone rubber, and in the hardening step, a step of applying a load to the conductive elastic material and the insulation portion, and a step of heating the conductive elastic material and the insulation portion at a predetermined temperature for a predetermined time are performed to harden the conductive elastic material and the insulation portion.

### Effects of Invention

According to the present invention, a manufacturing method of a conductive member for electrical test can be provided, in which the conductive member can accommodate downsizing of an electronic component.

### Brief Description of Drawings

[Fig. 1] A schematic cross-sectional view showing the configuration of a conductive member according to an embodiment of the present invention.
[Fig. 2] A schematic side view showing an example of arrangement of electrodes in an electronic component that is the tested object of an electrical test to be carried out using the conductive member shown in Fig. 1.
[Fig. 3] A schematic plan view showing an example of arrangement of the electrodes in the electronic component that is the tested object of an electrical test to be carried out using the conductive member shown in Fig. 1.
[Fig. 4] A schematic cross-sectional view showing an example of a glass substrate of the conductive member shown in Fig. 1.
[Fig. 5] A schematic cross-sectional view for showing a manufacturing method of the conductive member shown in Fig. 1, in which an electrode-portion forming step is shown.
[Fig. 6] A schematic cross-sectional view for showing the manufacturing method of the conductive member shown in Fig. 1, in which a resin-material layer forming step is shown.
[Fig. 7] A schematic cross-sectional view for showing the manufacturing method of the conductive member shown in Fig. 1, in which a via-hole forming step is shown.
[Fig. 8] A schematic cross-sectional view for showing the manufacturing method of the conductive member shown in Fig. 1, in which a filling step is shown.
[Fig. 9] A schematic cross-sectional view for showing the manufacturing method of the conductive member shown in Fig. 1, in which a separation step is shown.
[Fig. 10] A schematic cross-sectional view for showing the manufacturing method of the conductive member shown in Fig. 1, in which an insulation-portion forming step is shown.
[Fig. 11] A schematic cross-sectional view for showing the manufacturing method of the conductive member shown in Fig. 1, in which a hardening step is shown.
[Fig. 12] A schematic cross-sectional view showing an example of electrical test to be carried out on an electronic component by using the conductive member shown in Fig. 1.

### Description of Embodiments

Hereinafter, a manufacturing method of a conductive member according to an embodiment of the present invention, and the conductive member will be described with reference to the drawings.

### [Conductive member]

A conductive member according to one embodiment of the present invention is now described.

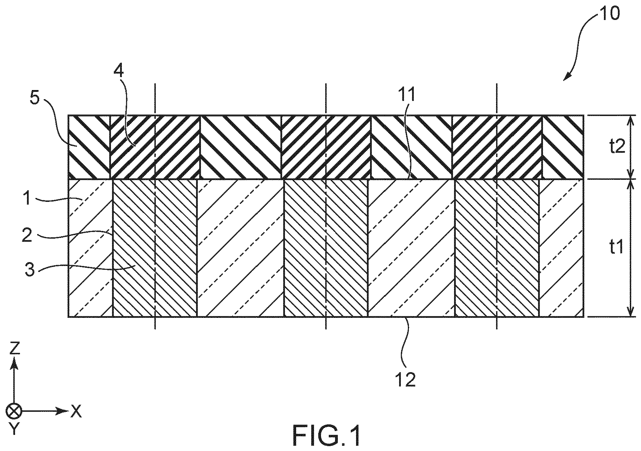

Fig. 1 is a schematic cross-sectional view showing the configuration of a conductive member 10 according to the embodiment of the present invention. In the following descriptions, a horizontal direction in the cross-sectional view of the conductive member 10 shown in Fig. 1 is defined as an X-axis direction, a direction perpendicular to the X-axis and extending through the drawing sheet is defined as a Y-axis direction, and a vertical direction perpendicular to the X-axis and the Y-axis is defined as a Z-axis direction. That is, the cross-sectional view shown in Fig. 1 is a X-Z cross-sectional view of the conductive member 10 in accordance with the definitions described above. In addition, in the following descriptions, all the cross-sectional views of the conductive member 10 are X-Z cross-sectional views of the conductive member 10 unless otherwise specified.

As shown in Fig. 1, the conductive member 10 includes a glass substrate 1, a through hole 2 provided in the glass substrate 1, and an electrode portion 3 formed of a conductive material filled in the through hole 2. The conductive member 10 is formed of a conductive elastic material, and further includes a contact portion 4 and an insulation portion 5. The contact portion 4 is joined to an exposed part of the electrode portion 3 on a topside 11 of the glass substrate 1. The insulation portion 5 is formed of an insulating elastic material around the contact portion 4 on the topside 11 of the glass substrate 1. Hereinafter, the configuration of the conductive member 10 is specifically described.

The glass substrate 1 is a plate member made of hard glass. The glass substrate 1 secures a mechanical strength sufficient for the conductive member 10. The glass substrate 1 has a thickness t1, for example, t1 = 100 to 300 µm. In the glass substrate 1, through holes 2 are formed apart from each other at a predetermined pitch, and pass through the glass substrate 1 between the topside 11 and an underside 12 that are opposed to each other. The topside 11 of the glass substrate 1 refers to the surface closer to the contact surface of the conductive member 10 with an electrode of an electronic component to be tested. The underside 12 of the glass substrate 1 refers to the surface on which the conductive member 10 contacts a conducting portion of a testing device for electrical test.

As described above, the electrode portion 3 is formed of a conductive material, for example, metal plating filled in the through hole 2. The electrode portion 3 is exposed to the outside of the glass substrate 1 from the topside 11 and the underside 12. An exposed part of the electrode portion 3, exposed to the outside from the underside 12, contacts the conducting portion of the testing device (not shown).

The contact portion 4 is joined to the exposed part of the electrode portion 3 with conductive properties on the topside 11 of the glass substrate 1, so that the contact portion 4 is electrically connected to an exposed part of the electrode portion 3 on the underside 12. The insulation portion 5 insulates a plurality of contact portions 4 from each other, and prevents the contact portions 4 from electrically contacting each other. The contact portion 4 and the insulation portion 5 have a thickness of, for example, t2 = 25 µm.

Next, an electrode 101 of an electronic component 100, to be contacted by the conductive member 10 during an electrical test, is described.

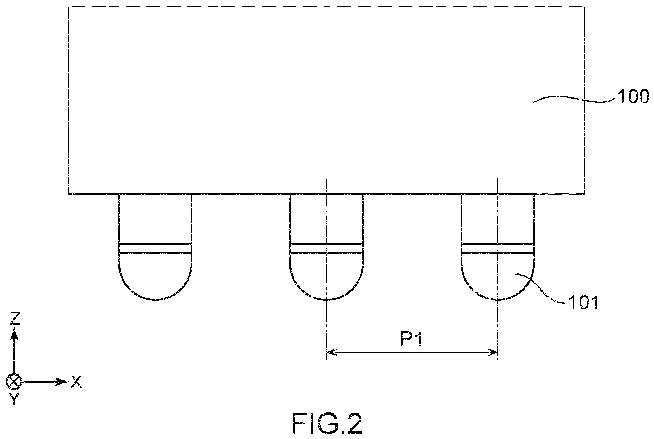

Fig. 2 is a schematic side view showing an example of arrangement of electrodes 101 of the electronic component 100 that is the tested object of an electrical test to be carried out using the conductive member 10. As shown in Fig. 2, in an array of the electrodes 101, a predetermined pitch P1 (for example, P1 = 55 µm) is provided in the X-axis direction. The electronic component 100 has a BGA package with hemispherical solders (solder balls) provided to serve as the electrodes 101 on the bottom portion of a package substrate.

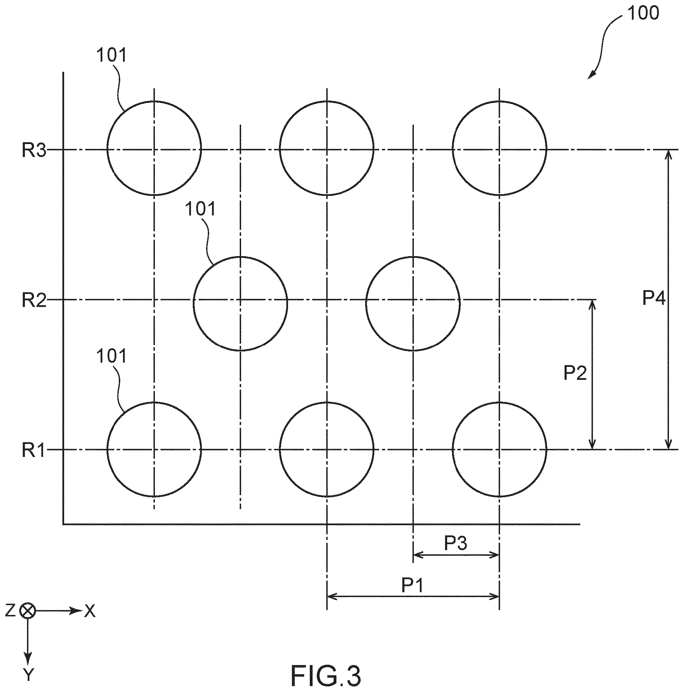

Fig. 3 is a schematic plan view showing an example of arrangement of the electrodes 101 of the electronic component 100 that is the tested object of an electrical test to be carried out using the conductive member 10. As shown in Fig. 3, in the electronic component 100, a plurality of rows of the electrodes 101 arrayed at the predetermined pitch P1 in the X-axis direction are arranged as a first row R1, a second row R2, a third row R3, ... in the Y-axis direction. For example, the rows of the electrodes 101 are arranged in a so-called staggered arrangement, in which the electrodes 101 on the second row R2 are alternately positioned in the middle between the electrodes 101 on the first row R1. A pitch P2 in the Y-axis direction between the electrodes 101 on the first row R1 and the electrodes 101 on the second row R2 is, for example, 48 µm. A pitch P3 in the X-axis direction between the electrodes 101 on the first row R1 and the electrodes 101 on the second row R2 is, for example, 27.5 µm. A pitch P4 in the Y-axis direction between the electrodes 101 on the first row R1 and the electrodes 101 on the third row R3 arrayed at the same pitch as those on the first row R1 is, for example, 96 µm.

The conductive member 10 electrically connects the electrode 101 of the electronic component 100 with a conducting portion 201 of a testing device 200 to be described later through the electrode portion 3 formed in, and the contact portion 4 formed on, the glass substrate 1 which are described above. The conductive member 10 includes the contact portion 4 formed of a conductive elastic material, and can thus prevent the electrode 101 from being broken during an electrical test. The conductive member 10 includes the contact portion 4 and the insulation portion 5 on the glass substrate 1, and can thus bring the electrode 101 and the conducting portion 201 corresponding to each other into proper contact. Therefore, the conductive member 10 can accommodate downsizing of the electronic component 100 for an electrical test on the electronic component 100.

Note that in the present invention, the array of the electrodes 101, the numerical values of the pitch of the electrodes 101, and other factors in the electronic component 100 to be tested are not limited to those described above.

### [Manufacturing method of conductive member]

A manufacturing method of the conductive member 10 according to one embodiment of the present invention is now described.

The manufacturing method of a conductive member according to the present embodiment is performed by the following steps. First, in the present manufacturing method, on the glass substrate 1 formed with a plurality of through holes 2, an electrode-portion forming step of forming the electrode portion 3 in each of the through holes 2, and a resin-material layer forming step of forming a resin-material layer 6 on the topside 11 of the glass substrate 1 are performed. In the present manufacturing method, after the resin-material layer forming step, a via-hole forming step of forming a via hole 7 in the resin-material layer 6 formed on the glass substrate 1 at a location corresponding to the top of the electrode portion 3, a filling step of filling the via hole 7 with a conductive elastic material 40, and a semi-hardening step of semi-hardening the conductive elastic material 40 are performed. In the present manufacturing method, after the semi-hardening step, a separation step of separating the resin-material layer 6, an insulation-portion forming step of forming the insulation portion 5 on the topside 11 of the glass substrate 1 by using an insulating elastic material, and a hardening step of hardening the insulation portion 5 along with the conductive elastic material 40 are performed. Hereinafter, the manufacturing method of the conductive member 10 is specifically described.

In the present manufacturing method, the glass substrate 1 formed with the through holes 2 is prepared for manufacturing the conductive member 10. As the glass substrate 1, an alkali-free glass with the thickness t1 can be used, for example. The through holes 2 can be provided in the glass substrate 1 by using a CO₂ laser, a hydrogen fluoride laser, or other types of laser. Note that a specific method for forming the through holes 2 in the glass substrate 1 is not limited to the example described above.

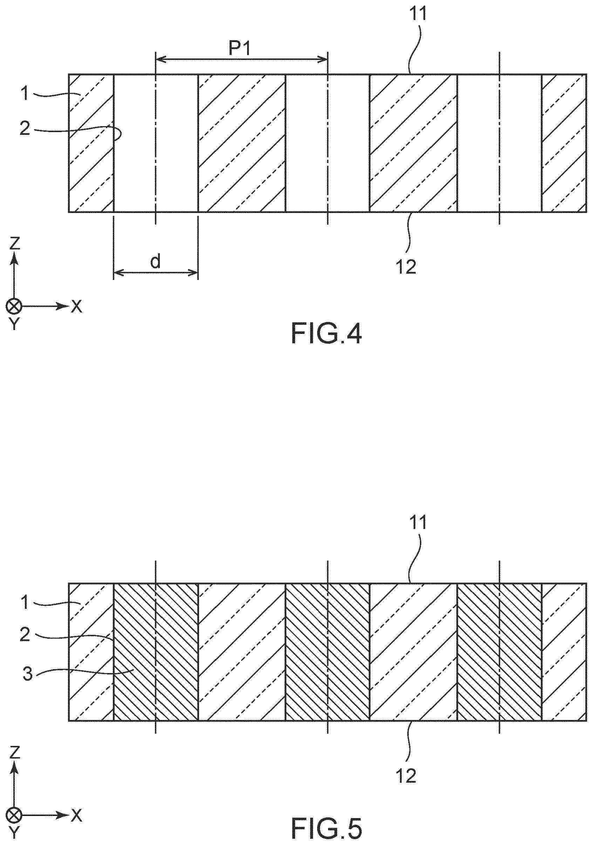

Fig. 4 is a schematic cross-sectional view showing an example of the glass substrate 1 of the conductive member 10. As shown in Fig. 4, the through holes 2 pass through the glass substrate 1 between the topside 11 and the underside 12, and have a predetermined hole diameter d (for example, d = 28 µm). The through holes 2 are formed corresponding to the array of the electrodes 101 of the electronic component 100 shown in Figs. 2 and 3 as the object on which an electrical test is carried out using the conductive member 10. That is, in an array of the through holes 2, the predetermined pitch P1 (for example, P1 = 55 µm) is provided in the X-axis direction in the same manner as the electrodes 101 of the electronic component 100. Also in the Y-axis direction, the through holes 2 are arrayed in a so-called staggered arrangement corresponding to the array of the electrodes 101 of the electronic component 100 described above, in which for example, the through holes 2 on the second row R2 are alternately positioned in the middle between the through holes 2 on the first row R1.

Note that in the present invention, the array of the through holes 2, and the pitch of the through holes 2 in the glass substrate 1 are not limited to the examples described above. That is, the array and other factors of the through holes 2 may not be the same as those of the electrodes 101 of the electronic component 100 as long as the array and other factors do not interfere with an electrical test on the electronic component 100.

### [Electrode-portion forming step]

First, an electrode-portion forming step in the manufacturing method of the conductive member 10 according to the present embodiment is described.

Fig. 5 is a schematic cross-sectional view for showing the manufacturing method of the conductive member, in which the electrode-portion forming step is shown. As shown in Fig. 5, in the electrode-portion forming step, a process of filling the through hole 2 in the glass substrate 1 with a conductive material, for example, a plating process is performed on the conductive member 10 to form the electrode portion 3. The electrode portion 3 is formed from, for example, three plated layers including a first plated portion, a second plated portion, and a third plated portion.

The first plated portion is formed to fill the inside of the through hole 2. The first plated portion is formed of, for example, copper plating.

The second plated portion is formed on a part of the electrode portion 3 exposed from the through hole 2 on the topside 11 and the underside 12 of the glass substrate 1. The second plated portion is formed of, for example, electroless nickel plating. The second plated portion has a thickness of, for example, 2 µm.

The third plated portion is formed on the surface of the second plated portion. The third plated portion is formed of, for example, electroless gold plating. The third plated portion has a thickness of, for example, 50 nm.

### [Resin-material layer forming step]

Next, a resin-material layer forming step in the manufacturing method of the conductive member 10 according to the present embodiment is described.

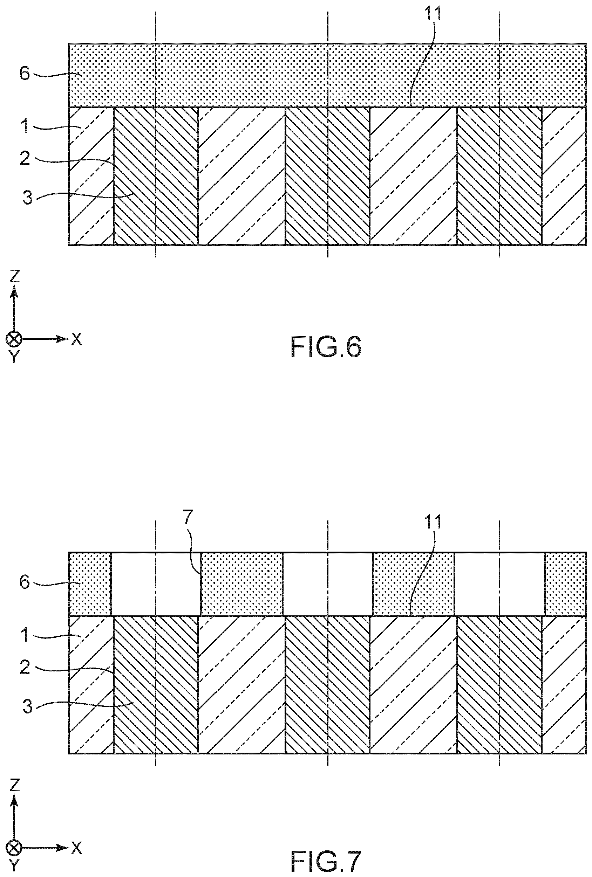

Fig. 6 is a schematic cross-sectional view for showing the manufacturing method of the conductive member 10, in which the resin-material layer forming step is shown. As shown in Fig. 6, in the resin-material layer forming step, the resin-material layer 6 is formed uniformly on the topside 11 of the glass substrate 1 having the electrode portion 3 formed in the through hole 2. The resin-material layer 6 is a resin film with photosensitivity that is, for example, a photosensitive polyimide film. The resin-material layer 6 has a thickness of, for example, 25 µm. The resin-material layer 6 is formed by laminating the photosensitive polyimide film described above on the topside 11 of the glass substrate 1, and then pressurizing and heating the laminated photosensitive polyimide film.

### [Via-hole forming step]

Next, a via-hole forming step in the manufacturing method of the conductive member 10 according to the present embodiment is described.

Fig. 7 is a schematic cross-sectional view for showing the manufacturing method of the conductive member 10, in which the via-hole forming step is shown. As shown in Fig. 7, in the via-hole forming step, the via hole 7 is formed in the resin-material layer 6 formed on the topside 11 of the glass substrate 1 at a location corresponding to the top of the electrode portion 3. The via hole 7 passes through the resin-material layer 6 between the topside of the resin-material layer 6 and the electrode portion 3. In the via-hole forming step, the via hole 7 is formed by performing a photolithography process on the resin-material layer 6 formed of the photosensitive polyimide film.

For example, the photolithography process in the via-hole forming step is performed in the following manner. First, by using a mask pattern through which the position of the via hole 7 to be formed is exposed to ultraviolet light, the resin-material layer 6 is exposed to the ultraviolet light to thereby form a latent image. After the exposure, the resin-material layer 6 undergoes thermal treatment. On the resin-material layer 6 having undergone the thermal treatment, a development process is performed using a developer, so that a portion with the latent image is removed and consequently the via hole 7 is formed. The photolithography process in the via-hole forming step is not limited to the example described above. Various methods can be used.

### [Filling step]

Next, a filling step in the manufacturing method of the conductive member 10 according to the present embodiment is described.

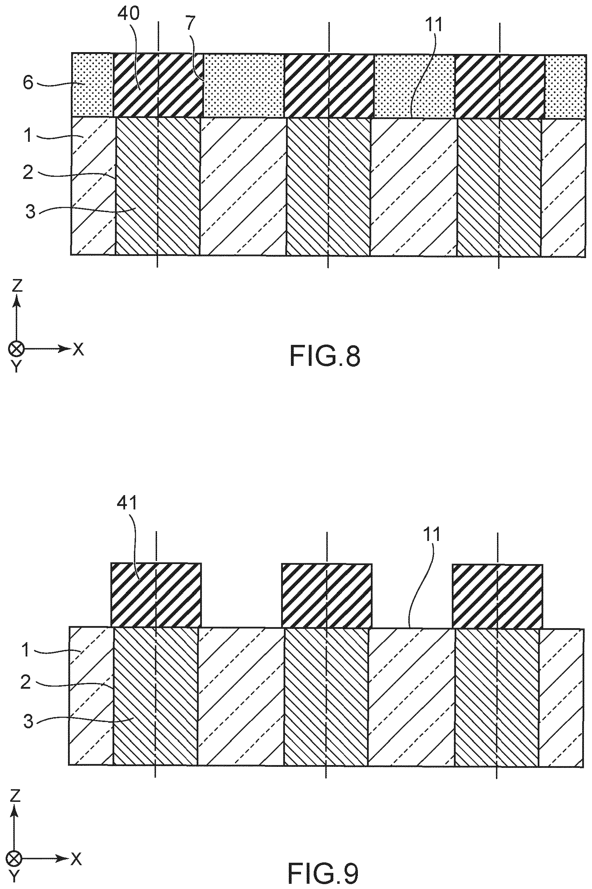

Fig. 8 is a schematic cross-sectional view for showing the manufacturing method of the conductive member 10, in which the filling step is shown. As shown in Fig. 8, in the filling step, the via hole 7 is filled with the conductive elastic material 40 to form the contact portion 4 within the via hole 7. The conductive elastic material 40 is formed by, for example, including particles with conductive properties (hereinafter, referred to as "conductive particles") in a silicone rubber serving as a binder. For example, as the conductive particles, nickel particles with an average particle diameter of 2.5 µm, which are coated with gold plating at a weight ratio of 30% with a film thickness of 50 nm, are used. In the conductive elastic material 40, with respect to 100 parts-by-weight of the above silicone rubber, 900 parts-by-weight of the above conductive particles are combined and mixed with the silicone rubber into a paste. The conductive elastic material 40 is squeegeed by using a rubber blade, and thus filled in the via hole 7.

### [Semi-hardening step]

Next, a semi-hardening step in the manufacturing method of the conductive member 10 according to the present embodiment is described.

The conductive elastic material 40 filled in the via hole 7 is semi-hardened by, for example, primary vulcanization at a temperature of 100°C for 30 minutes.

### [Separation step]

Next, a separation step in the manufacturing method of the conductive member 10 according to the present embodiment is described.

Fig. 9 is a schematic cross-sectional view for showing the manufacturing method of the conductive member 10, in which the separation step is shown. Fig. 9 shows the glass substrate 1 after the resin-material layer 6 has been separated. In the separation step, the resin-material layer 6 shown in Fig. 8 and other drawings is separated from the topside 11 of the glass substrate 1 by an etching process. For example, a specific etching process is performed by soaking the glass substrate 1 having the resin-material layer 6 affixed thereto in a solution with a concentration of tetramethylammonium hydroxide (TMAH) of 2.38% for 30 minutes. The resin-material layer 6 is separated from the topside 11 of the glass substrate 1 by performing the etching process. The resin-material layer 6 is separated, and consequently the semi-hardened conductive elastic material 40 only remains at the position atop the electrode portion 3 on the topside 11 of the glass substrate 1. This semi-hardened conductive elastic material 40 becomes a conducting rubber pillar 41 that has a columnar or substantially columnar shape and that functions as the contact portion 4 after manufacturing of the conductive member 10 has been completed.

### [Insulation-portion forming step]

Next, an insulation-portion forming step in the manufacturing method of the conductive member 10 according to the present embodiment is described.

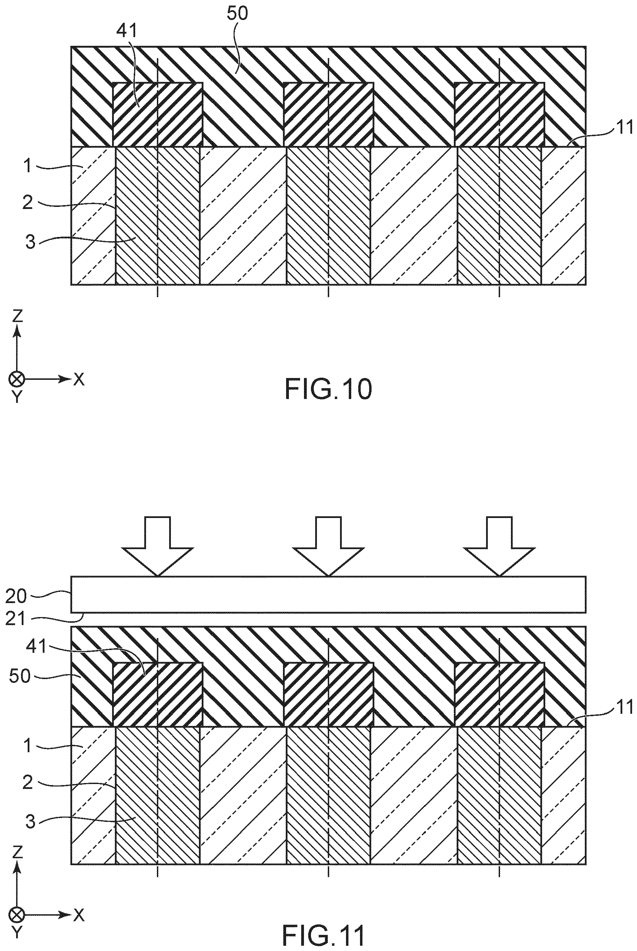

Fig. 10 is a schematic cross-sectional view for showing the manufacturing method of the conductive member 10, in which the insulation-portion forming step is shown. In the insulation-portion forming step, on the topside 11 of the glass substrate 1 formed with the conducting rubber pillar 41, droplets of an insulating elastic material 50, such as a binder silicone rubber that does not include conductive particles or other conductive material, are dropped around the conducting rubber pillar 41 to form the insulation portion 5.

### [Hardening step]

Lastly, a hardening step in the manufacturing method of the conductive member 10 according to the present embodiment is described.

Fig. 11 is a schematic cross-sectional view for showing the manufacturing method of the conductive member 10, in which the hardening step is shown. In the hardening step, a flat plate 20 is used, for example, to apply a load from above to the conducting rubber pillar 41 and the insulating elastic material 50 formed on the topside 11 of the glass substrate 1. A release film 21 is affixed to a contact surface of the flat plate 20 with the conducting rubber pillar 41 and the insulating elastic material 50. In the hardening step, in a state where the conducting rubber pillar 41 and the insulating elastic material 50 are applied with a load from above, the conducting rubber pillar 41 and the insulating elastic material 50 are heated at a predetermined temperature (for example, 150°C) for a predetermined time (for example, two hours). The steps described above are performed, and consequently on the topside 11 of the glass substrate 1, the insulating elastic material 50 becomes hardened and the insulation portion 5 is formed. Along with that, the semi-hardened conducting rubber pillar 41 becomes fully hardened and thereby the contact portion 4 is formed.

Through the hardening step, the conducting rubber pillar 41 and the insulating elastic material 50 become hardened, and then the contact portion 4 that is electrically conducted with the electrode portion 3, and the insulation portion 5 that insulates the contact portions 4 from each other are formed on the topside 11 of the glass substrate 1. Thus, manufacturing of the conductive member 10 shown in Fig. 1 is completed.

### [Example of use of conductive member]

Next, an example of electrical test using the conductive member 10 explained above is described.

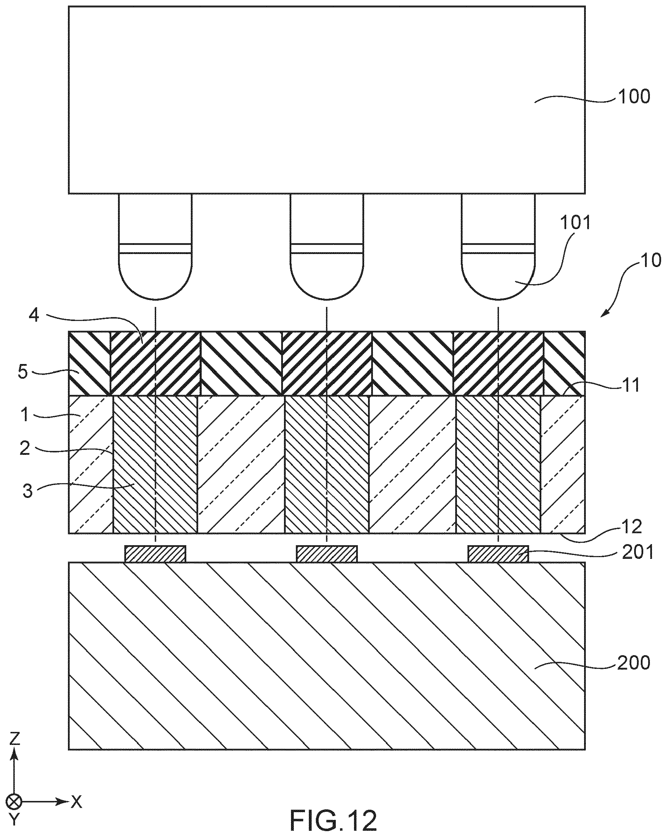

Fig. 12 is a schematic cross-sectional view showing an example of electrical test to be carried out on the electronic component 100 by using the conductive member 10. As shown in Fig. 12, when an electrical test is carried out to test a conducting state of the electrode 101 of the electronic component 100 such as a semiconductor integrated circuit by means of bringing the electrode 101 into contact with the conducting portion 201 of the testing device 200, the conductive member 10 is interposed between the electrode 101 and the conducting portion 201. That is, in the conductive member 10, the contact portion 4 contacts the electrode 101, while the electrode portion 3 exposed on the underside 12 of the glass substrate 1 contacts the conducting portion 201.

For the purpose of evaluating the conductive member 10 according to the present embodiment, the value of electrical resistance of the conductive member 10 is measured using a gold-plated current-carrying probe needle as an equivalent to the electrode 101 of the electronic component 100 with an electrode diameter of 25 µm. The needle is applied with a load and brought into contact with the electrode portion 3 and the contact portion 4. This results in the value of electrical resistance of 100 mΩ relative to a load of 1 gf applied by the needle. According to the conductive member 10, a conductive member for electrical test that has a proper value of electrical resistance can be obtained.

The conductive member 10 includes the contact portion 4 formed of a conductive elastic material on the topside 11 of the glass substrate 1 atop the electrode portion 3, and can thus protect the electrode 101 from being broken during an electrical test.

The conductive member 10 includes the contact portion 4 formed of a conductive elastic material, and the insulation portion 5 formed of an insulating elastic material on the hard glass substrate 1. With this configuration, the conductive member 10 can obtain a mechanical strength (rigidity) sufficient for a pressing force applied by the testing device 200 during an electrical test. The conductive member 10 includes the electrode portion 3 in the through hole 2 provided in the glass substrate 1, and further includes the contact portion 4 formed by the photolithography process. Thus, even when the distance between the electrode portions 3 adjacent to each other is minute, while the distance between the contact portions 4 adjacent to each other is minute, the positional accuracy of both the electrode portions 3 and the contact portions 4 can still be obtained. That is, the conductive member 10 can bring the electrode 101 and the conducting portion 201 into proper contact with each other even during an electrical test on the electronic component 100 that is downsized with a reduced pitch of the electrodes 101.

Therefore, according to the present embodiment, the conductive member 10 for electrical test that can accommodate downsizing of the electronic component 100, and the manufacturing method of the conductive member 10 can be provided.

While the embodiment of the present invention has been described above, the present invention is not limited to the manufacturing method of a conductive member, or the conductive member 10 according to the above embodiment of the present invention. The present invention includes various aspects within the concept and claims of the present invention. Each component may be appropriately and optionally combined to solve or provide at least part of the above-described problems or effects. For example, the shape, material, arrangement, size, and other factors of each component according to the above embodiment may be appropriately changed depending on a specific use of the present invention.

### List of Reference Signs

- 1: glass substrate,
- 2: through hole,
- 3: electrode portion,
- 4: contact portion,
- 5: insulation portion,
- 6: resin-material layer,
- 7: via hole,
- 10: conductive member,
- 11: topside,
- 12: underside,
- 20: flat plate,
- 21: release film,
- 40: conductive elastic material,
- 41: conducting rubber pillar,
- 100: electronic component,
- 101: electrode,
- 200: testing device,
- 201: conducting portion

## Claims

1. A manufacturing method of a conductive member, the method comprising:
an electrode-portion forming step of, on a glass substrate formed with a plurality of through holes, forming an electrode portion in each of the through holes;
a resin-material layer forming step of forming a resin-material layer on a topside of the glass substrate;
a via-hole forming step of forming a via hole in a resin-material layer formed on the glass substrate at a position atop the electrode portion;
a filling step of filling the via hole with a conductive elastic material;
a semi-hardening step of semi-hardening the conductive elastic material;
a separation step of separating the resin-material layer;
an insulation-portion forming step of forming an insulation portion on a topside of the glass substrate by using an insulating elastic material; and
a hardening step of hardening the insulation portion along with the conductive elastic material.

2. The manufacturing method of a conductive member according to claim 1, wherein
the resin-material layer is formed of a resin material with photosensitivity, and
in the via-hole forming step, the via hole is formed by performing a photolithography process on the resin-material layer at a position atop the electrode portion.

3. The manufacturing method of a conductive member according to claim 1 or 2, wherein in the separation step, the resin-material layer is separated from a topside of the glass substrate by an etching process.

4. The manufacturing method of a conductive member according to any of claims 1 to 3, wherein
the insulating elastic material is a silicone rubber, and
in the hardening step, a step of applying a load to the conductive elastic material and the insulation portion, and a step of heating the conductive elastic material and the insulation portion at a predetermined temperature for a predetermined time are performed to harden the conductive elastic material and the insulation portion.
